# EUROPÄISCHE PATENTSCHRIFT

(11) **EP 1 743 220 B1**
(45) Veröffentlichungstag und Bekanntmachung des Hinweises auf die Patenterteilung: **16.06.2010**
(21) Anmeldenummer: 05738799.5
(22) Anmeldetag: 19.04.2005
(51) Int. Cl.: G03F 7/16

(54) **VORRICHTUNG ZUM DREHBELACKEN VON SUBSTRATEN**
DEVICE FOR COVERING SUBSTRATES IN A ROTATING MANNER
DISPOSITIF DE REVETEMENT ROTATIF DE SUBSTRATS

(30) Priorität: 20.04.2004 DE 102004019731
(43) Veröffentlichungstag der Anmeldung: 17.01.2007
(73) Patentinhaber: SSE Sister Semiconductor Equipment GmbH, 78224 Singen (DE)
(72) Erfinder: HOFFMANN, Dirk, 78354 Sipplingen (DE)
(74) Vertreter: Dobler, Markus
(86) Internationale Anmeldenummer: PCT/DE2005/000712
(87) Internationale Veröffentlichungsnummer: WO 2005/103825

(56) Entgegenhaltungen:
- WO-A-02/071154
- US-A- 5 611 886
- US-A- 5 718 763
- US-A- 5 861 061
- US-A- 6 068 881
- US-A1- 2001 009 135
- PATENT ABSTRACTS OF JAPAN Bd. 008, Nr. 206 (E-267), 20. September 1984 (1984-09-20) & JP 59 090928 A (DAINIHON SCREEN SEIZOU KK), 25. Mai 1984 (1984-05-25)

## Beschreibung

Die Erfindung betrifft eine Vorrichtung zum Drehbelacken von Substraten nach dem Oberbegriff des Anspruchs 1.

### Stand der Technik:

In der Halbleitertechnik sind Dreh- bzw. Spinbelacker, die auch Coater genannt werden, insbesondere zum Aufbringen von Fotolack auf Substrate, z.B. Wafer oder Glasscheiben, aber auch für andere flüssige Medien in vielfältigen Ausführungsformen bereits bekannt.

Für reproduzierbare Herstellungsprozesse mit großer Ausbeute ist ein entscheidendes Kriterium, das flüssige Medium, z.B. ein Fotolack als möglichst homogene Schicht, auch bei vergleichsweise großen Substraten mit aufbringen zu können.

Bei einer Ausführungsform wird für den "Spinvorgang" eine Abdeckeinheit eingesetzt, die über das zu belackende Substrat abgesenkt wird. Damit soll ein Lösungsmittelpolster auf dem Substrat bzw. dem aufgebrachten flüssigen Medium erzeugt werden, was beim Spinvorgang zu einer gleichmäßigeren Schicht führt. Ohne eine Abdeckung würde ein normalerweise Laminarflow in Reinräumen eine unerwünschte "Abtrocknung" des aufzubringenden flüssigen Mediums zur Folge haben.

### Stand der Technik:

Es ist Aufgabe der vorliegenden Erfindung, eine Vorrichtung zum Drehbelacken der eingangs genannten Art bereitzustellen, die einen verbesserten Auftrag von flüssigen Medien erlaubt.

Diese Aufgabe wird durch die Merkmale des Anspruchs 1 gelöst.

In den Unteransprüchen sind vorteilhafte und zweckmäßige Weiterbildungen der Erfindung angegeben.

Die Erfindung geht von einer Vorrichtung zum Drehbelacken von Substraten mit flüssigen Medien aus, die einen drehbaren Substrathalter (Chuck) zur horizontalen Auflage von Substraten und eine Abdeckeinheit zum Abdecken des Substrats während eines Verteilvorgangs des flüssigen Mediums durch Drehen (Spinnen) des Substrathalters umfasst. Ein wesentlicher Aspekt der Erfindung liegt nun darin, dass der Substrathalter mit der Abdeckeinheit dicht zusammenfügbar ist und umfänglich angeordnete Durchgangslöcher vorgesehen sind, über welche der aus Abdeckeinheit und Substratteller gebildete Belackungsinnenraum aber nach wie vor nach außen verbunden ist.

Ein weiterer wesentlicher Aspekt der Erfindung ist darin zu sehen, dass im Abstand zu den umfänglich angeordneten Durchgangslöchern ein Wandabschnitt derart vorgesehen, dass während des Spinvorgangs die Durchgangslöcher zum Wandabschnitt eine Relativbewegung ausführen. Hierdurch wird begünstigt, dass die Atmosphäre zwischen dem Wandabschnitt und den sich drehenden Teilen der Belackungsvorrichtung während des Spinnens weniger mitgerissen wird und so der Grad der Relativbewegung vergrößert ist. Dadurch wird der "Venturi-Effekt" in den Durchgangslöchern verstärkt, was zu einer erhöhten Absaugwirkung führt. Diese ist in einem vorgegebenen Maß erwünscht. Denn dadurch wird überschüssiges Medium nahezu vollständig über die Durchgangslöcher abgesaugt und zudem hat diese Maßnahme positiven Einfluss auf die aufgebrachte Schichthomogenität.

Offensichtlich wird ein Mitreißen der Atmosphäre im Bereich um die sich drehenden Teile (Substrathalter, Abdeckeinheit) über den Wandabschnitt reduziert, weil die Atmosphäre am Wandabschnitt "reibt".

Durch diese Maßnahme wird nicht nur eine vergleichsweise gute Homogenität einer "aufgespinnten" Schicht erzielt, sondern auch die Möglichkeit gegeben, gleichzeitig überschüssiges Medium mittels der Durchgangslöcher gezielt abzuführen.

Dazu tragen insbesondere zwei Effekte bei: Zunächst treten Fliehkräfte beim Spinvorgang auf, die das aufgebrachte Medium radial nach außen in den Umfangsbereich verteilen bzw. verdrängen. Die Durchgangslöcher, z.B. Bohrungen sind vorzugsweise radial angeordnet, um einen Abtransport von überschüssigen abgespinnten Medium zu begünstigen. Darüber hinaus entsteht in den Durchgangslöchern beim schnellen Drehen des Substrathalters eine Art Venturi-Effekt mit einer Strömung in radialer Richtung nach außen, da die Löcher durch die Drehbewegung eine Relativbewegung zu der umgebenden Atmosphäre bei der Drehbewegung durchführen, wodurch aus den Durchgangslöchern Medium und Atmosphäre nach außen abgesaugt wird, mit der Folge einer Unterdruckbildung im Belackungsinnenraum.

Vorzugsweise sind die Durchgangslöcher im Bereich einer Umfangswand, z.B. des Substrathalters angeordnet. Die Anordnung der Durchgangslöcher, z.B. Bohrungen, ist günstigerweise radial, gegebenenfalls mit einem vorgegebenen Neigungswinkel aus der Horizontalen beispielsweise etwas nach unten gekippt. Hierdurch wird der Abströmvorgang weiter unterstützt.

Um eine Unterdruckbildung im Belackungsinnenraum zu fördern, wird außerdem vorgeschlagen, dass zwischen Abdeckeinheit und Substrathalter Dichtmittel vorgesehen sind. Beispielsweise ist auf einer kreisringförmigen Stirnwand des Substrathalters ein O-Ring angeordnet, der eine dichte Verbindung zwischen Substrathalter und einer darauf aufliegenden Abdeckeinheit ermöglicht.

Die Absaugwirkung insbesondere im Hinblick auf den Venturi-Effekt wird durch die Durchgangslöcher und/oder die Ausbildung des Wandabschnitts und/oder die Art und Weise, wie die Durchgangslöcher in Bezug zum Wandabschnitt stehen, bestimmt .

Um eine gewünschte Strömung in den Durchgangslöchern zu erhalten, wird bevorzugt Einfluss über den Abstand der Durchgangslöcher zum Wandabschnitt bzw. auf die Form des Wandabschnitts und damit die Ausrichtung einer Wandabschnittoberfläche genommen. In einer bevorzugten Ausführungsform ist der weitgehend rotationssymmetrische Substrathalter in einer rotationssymmetrischen Wanneneinheit drehbar angeordnet, die einen rotationssymmetrischen, mantelförmigen, z.B. kegelmantelförmigen Wandabschnitt, gegebenenfalls mit über die Mantelhöhe gekrümmter Fläche im Bereich der Durchgangslöcher besitzt. Der Wandabschnitt weist vorzugsweise einen vorgegebenen Abstand mit einem vorbestimmten Neigungswinkel im Bereich der Durchgangslöcher auf, insbesondere ist der Mantelabschnitt nach unten aufgeweitet.

Für z.B. ein Belacken mit Fotolack ist der Abstand bevorzugt so einzustellen, dass ein ausreichender Absaugeffekt in den Durchgangslöchern auftritt, aber das abgesaugte Medium mit dem umgebenden Wandabschnitt nicht in einer Weise interagiert, dass eine Fadenbildung zwischen den sich drehenden Teilen und dem Wandabschnitt auftritt.

Die Rotationsgeschwindigkeit von Substrathalter mit Abdeckeinheit kann im Bereich von wenigen Umdrehungen pro Minute bis mehrere hundert Umdrehungen pro Minute liegen. Die Rotationsgeschwindigkeit hat dabei neben den geometrischen Gegebenheiten einen starken Einfluss auf die Absaugwirkung in den Durchgangslöchern.

### Beschreibung des Ausführungsbeispiels:

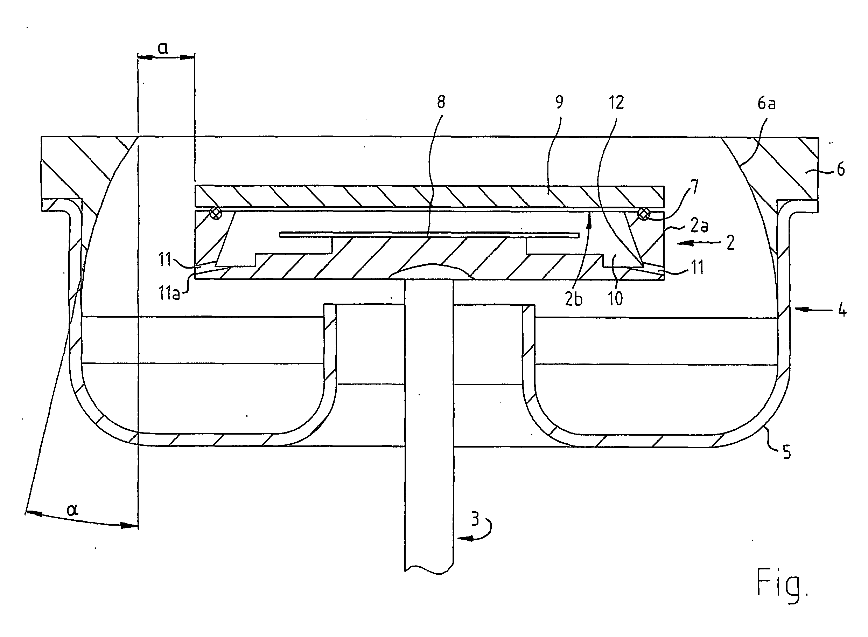

Ein Ausführungsbeispiel der Erfindung ist in der einzigen Figur dargestellt.

Die Figur zeigt in einer schematischen Schnittansicht einen "Spinbelacker" mit zu belackenden Substrat.

Der Spinbelacker 1 umfasst einen drehbaren Substratteller 2 mit einer Drehwelle 3, der konzentrisch in einer kreisringförmigen Auffangwanne 4 angeordnet ist. Die Auffangwanne 4 umfasst ein kreisringförmiges Basisteil 5, das gegebenenfalls mit einer Absaugung (nicht dargestellt) ausgestattet ist und einem rotationssymmetrischen Aufsatz 6, der über seine Höhe einen leicht gebogenen kegelmantelförmigen Innenwandabschnitt 6a, welcher zum Substratteller 2 zeigt, definiert. Die Biegung kann einer beliebigen Kurve folgen. Der Substratteller 2 besitzt eine Umfangswand 2a, in deren kreisringförmiger Stirnwand ein O-Ring 7 eingefügt ist.

Während eines Spinvorgangs nach Aufbringen eines zu belackenden Mediums auf ein Substrat 8 wird ein Abdeckelement 9 aufgesetzt, das über den O-Ring 7 die Öffnung 2b des Substrattellers 2 dicht verschließt. Der dadurch entstehende Belackungsinnenraum 10 ist aber dann nicht hermetisch nach außen abgeschlossen, sondern steht über Durchgangslöcher 11 mit der Atmosphäre der Auffangwanne 4 in Verbindung. Die Durchgangslöcher sind vorzugsweise als Durchgangsbohrungen ausgestaltet, deren Längsachse radial verläuft. Mehrere Durchgangsbohrungen 11 sind beispielsweise gleichmäßig über den Umfang der Umfangswand 2a des Substrattellers 2 in dessen unterem Bereich verteilt. Bevorzugt ist eine rotationssymmetrische Anordnung aus Homogenitätsgründen der zu erzeugenden Schicht. Die Durchgangsbohrungen 11 sind leicht nach unten abgekippt, um ein Absaugeffekt von überschüssigem Medium zu begünstigen. Begünstigt wird der Abfließvorgang auch dadurch, dass die Durchgangsbohrungen 11 in einer unteren radial außen liegenden Ecke 12 des Belackungsinnenraums 10 ansetzen.

Ein Abstand a der Umfangswand 2a zum Wandabschnitt 6a ist vorzugsweise kleiner 20 mm - 30 mm und beträgt insbesondere 10 mm. Einen Einfluss auf das Absaugverhalten durch die Durchgangsbohrungen 11 hat überdies die Neigung des Wandabschnitts 6a. Dieser beträgt im vorliegenden Fall α = 20°. Durch die Neigung wird der Abstand des Wandabschnitts 6a zu den Ausgängen 11a der Durchgangsbohrungen 11 bestimmt, was Einfluss auf das Verhalten der Atmosphäre zwischen dem Ausgang 11a der Durchgangslöcher 11 und dem in einem Bereich in einer Ebene radial gegenüberliegenden Wandabschnittsbereich hat. Dies wiederum wirkt sich auf das Absaugverhalten in den Durchgangsbohrungen 11 aus.

Beim Spinvorgang mit geschlossenem Abdeckelement 9 bildet sich eine Strömung in den Durchgangsbohrungen 11 aus, die überschüssiges Material nach außen abzieht, im Wesentlichen vollständig abzieht und zudem einen Unterdruck im Belackungsinnenraum 10 erzeugt. Hierdurch wird ein homogener Schichtauftrag auf das Substrat 8 begünstigt.

Bezugszeichenliste:
- 1: Spinbelacker
- 2: Substratteller
- 2a: Umfangswand
- 2b: Öffnung
- 3: Drehwelle
- 4: Auffangwanne
- 5: Basisteil
- 6: Aufsatz
- 6a: Wandabschnitt
- 7: O-Ring
- 8: Substrat
- 9: Abdeckelement
- 10: Belackungsinnenraum
- 11: Durchgangslöcher
- 11a: Ausgang
- 12: Ecke

## Patentansprüche

1. Vorrichtung zum Drehbelacken von Substraten mit flüssigen Medien mit einem drehbaren Substratteller (2) zur horizontalen Auflage eines Substrats (8) und einer Abdeckeinheit (9) zum Abdecken des Substrats (8) während eines Verteilvorgangs des flüssigen Mediums durch Drehen des Substrathalters (2), wobei der Substrathalter (2) mit der Abdeckeinheit (9) dicht zusammenfügbar ist, jedoch umfänglich angeordnete Durchgangslöcher (11) vorgesehen sind, über welche der aus Abdeckeinheit (9) und Substrathalter (2) gebildete Belackungsinnenraum (10) nach wie vor nach außen in Verbindung steht, **dadurch gekennzeichnet, dass** im Abstand zu den umfänglich angeordneten Durchgangslöcher (11) ein radial gegenüberliegender Wandabschnitt (6a) vorgesehen ist, wobei während des Drehbelackens die Durchgangslöcher (11) zum Wandabschnitt (6a) eine Relativbewegung ausführen.

2. Vorrichtung nach Anspruch 1, **dadurch gekennzeichnet, dass** die Durchgangslöcher im Bereich einer Umfangswand (2a) angeordnet sind.

3. Vorrichtung nach einem der vorhergehenden Ansprüche, **dadurch gekennzeichnet, dass** der Substrathalter eine Umfangswand (2a) umfasst.

4. Vorrichtung nach einem der vorhergehenden Ansprüche, **dadurch gekennzeichnet, dass** zwischen Abdeckeinheit (9) und Substrathalter (2) Dichtmittel (7) vorgesehen sind.

5. Vorrichtung nach einem der vorhergehenden Ansprüche, **dadurch gekennzeichnet, dass** die Durchgangslöcher (11) und/oder der Wandabschnitt (6a) und/oder die Durchgangslöcher (11) in Bezug den Wandabschnitt (6a) so ausgestaltet sind, dass in den Durchgangslöchern (11) und damit im Belackungsinnenraum (9) bei der Relativbewegung von Wandabschnitt (6a) in Durchgangslöchern (11) ein vorgegebener Unterdruck entsteht.

6. Vorrichtung nach einem der vorhergehenden Ansprüche, **dadurch gekennzeichnet, dass** der Abstand der Durchgangslöcher (11) zum Wandabschnitt (6a) und/oder die Ausrichtung des Wandabschnitts (6a) derart ist, dass ein gewünschter Gasstrom in den Durchgangslöchern (11) während des Drehbelackungsvorgangs auftritt.

7. Vorrichtung nach einem der vorhergehenden Ansprüche, **dadurch gekennzeichnet, dass** der Substrathalter (2) in einer Wanneneinheit (4) drehbar angeordnet ist, die einen mantelförmigen Wandabschnitt (6a) im Bereich der Durchgangslöcher (11) umfasst.

## Claims

1. Device for covering substrates with liquid media in a rotating manner with a rotatable substrate plate (2) for horizontally supporting a substrate (8) and a cover unit (9) for covering the substrate (8) during a distribution process of the liquid medium by rotation of the substrate holder (2), wherein the substrate holder (2) can be joined tightly to the cover unit (9), but circumferentially arranged through holes (11) are provided, by means of which the inner coating space (10) formed by the cover unit (9) and substrate holder (2) remains connected to the outside, **characterised in that** at a distance from the circumferentially arranged through holes (11) a radially opposite wall section (6a) is provided, wherein during the rotational coating the through holes (11) perform a movement relative to the wall section (6a).

2. Device according to claim 1, **characterised in that** the through holes are arranged in the region of a circumferential wall (2a).

3. Device according to one of the preceding claims, **characterised in that** the substrate holder comprises a circumferential wall (2a).

4. Device according to one of the preceding claims, **characterised in that** sealing means (7) are provided between the cover unit (9) and substrate holder (2).

5. Device according to one of the preceding claims, **characterised in that** the through holes (11) and/or the wall section (6a) and/or the through holes (11) are designed in relation to the wall section (6a), so that in the through holes (11) and thus in the inner coating space (9) upon the relative movement of the wall section (6a) in through holes (11) a predefined low pressure is established.

6. Device according to one of the preceding claims, **characterised in that** the spacing of the through holes (11) from the wall section (6a) and/or the alignment of the wall section (6a) is such that a desired gas flow occurs in the through holes (11) during the rotational coating process.

7. Device according to one of the preceding claims, **characterised in that** the substrate holder (2) is arranged rotatably in a tank unit (4), which comprises a sleeve-like wall section (6a) in the region of the through holes (11).

## Revendications

1. Dispositif de vernissage par rotation de substrats avec des agents liquides à l'aide d'un plateau à substrat (2), rotatif, recevant en position horizontale un substrat (8) ainsi qu'un couvercle (9) pour couvrir le substrat (8) pendant l'opération de répartition de l'agent liquide par rotation du support de substrat (2), dispositif dans lequel
le support de substrat (2) est assemblé de manière étanche au couvercle (9) avec toutefois des orifices traversants (11) répartis en périphérie, par lesquels le volume intérieur de vernissage (10) entouré par le couvercle (9) et le support de substrat (2), reste toujours en communication avec l'extérieur,
**caractérisé par**
un segment de paroi (6a) radialement en regard et à distance des orifices traversants (11) prévus en périphérie,
et pendant l'opération de vernissage, les orifices traversants (11) effectuent un mouvement relatif par rapport au segment de paroi (6a).

2. Dispositif selon la revendication 1,
**caractérisé en ce que**
les orifices traversants sont au niveau d'une paroi périphérique (2a).

3. Dispositif selon l'une des revendications précédentes,
**caractérisé en ce que**
le plateau à substrat comporte une paroi périphérique (2a).

4. Dispositif selon l'une des revendications précédentes,
**caractérisé par**
un moyen d'étanchéité (7) entre le couvercle (9) et le support de substrat (2).

5. Dispositif selon l'une des revendications précédentes,
**caractérisé en ce que**
les orifices traversants (11) et/ou le segment de paroi (6a) et/ou les orifices traversants (11) sont réalisés par rapport au segment de paroi (6a) de façon à développer une dépression déterminée dans les orifices traversants (11) et ainsi dans le volume intérieur de vernissage (9) par le mouvement relatif du segment de paroi (5a).

6. Dispositif selon l'une des revendications précédentes,
**caractérisé en ce que**
la distance entre les orifices traversants (11) et le segment de paroi (6a) et/ou l'alignement du segment de paroi (6a) est telle qu'elle génère un flux de gaz souhaité à travers les orifices traversants (11) au cours de l'opération de vernissage par rotation.

7. Dispositif selon l'une des revendications précédentes,
**caractérisé en ce que**
le support de substrat (2) est monté à rotation dans une cuvette (4) ayant un segment de paroi (6a) en forme d'enveloppe au niveau des orifices traversants (11).
